(19) Europäisches Patentamt
European Patent Office
Office européen des brevets

(11) **EP 4 779 277 A1**

(12) **EUROPEAN PATENT APPLICATION**

(43) Date of publication:
22.07.2026 Bulletin 2026/30

(21) Application number: 25152753.7

(22) Date of filing: 20.01.2025

(51) International Patent Classification (IPC):
**G01K 7/01** (2006.01)    **G01K 3/14** (2006.01)
**G01K 1/02** (2021.01)    **G06K 19/07** (2006.01)
**H03M 1/12** (2006.01)

(52) Cooperative Patent Classification (CPC):
**G01K 7/01; G01K 1/026; G01K 3/14;**
**G06K 19/0717; G06K 19/0723; H03M 1/12;**
G01K 2219/00

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **NXP B.V.**
**5656 AG Eindhoven (NL)**

(72) Inventor: **Buter,, Berry Anthony Johannus**
**5656 AG Eindhoven (NL)**

(74) Representative: **Schwarzweller, Thomas**
**NXP Semiconductors Germany GmbH**
**Intellectual Property Group**
**Beiersdorfstraße 12**
**22529 Hamburg (DE)**

(54) **A TEMPERATURE SENSING CIRCUIT**

(57) A temperature-sensing-circuit comprising: an analogue-to-digital-converter; a first-active-device defining a first-current-density when receiving a first-current; a second-active-device defining a second-current-density when receiving a second-current (being different to the first-current-density); a comparison-block to provide a difference-signal to the analogue-to-digital-converter, representing a difference between a voltage-drop across the first-active-device and a voltage-drop across the second-active-device; a satellite-active-device defining a satellite-current-density when receiving a satellite-current; a multiplexer comprising: a first-input-terminal to receive the voltage-drop across the first-active-device; a satellite-input-terminal to receive a voltage-drop across the satellite-active-device; and an output-terminal to provide one of the received signals to the analogue-to-digital-converter; and a controller configured to: cause the multiplexer to provide the voltage-drop across the first-active-device, so the analogue-to-digital-converter provides a reference-ratio-signal (a ratio between the difference-signal and the voltage-drop across the first-active-device); cause the multiplexer to provide the voltage-drop across the satellite-active-device so the analogue-to-digital-converter provides a satellite-ratio-signal (a ratio between the difference-signal and the voltage-drop across the satellite-active-device); and determine a temperature difference between the first-active-device and the satellite-active-device from a comparison between the reference-ratio-signal and the satellite-ratio-signal.

Figure 1

EP 4 779 277 A1

## Description

### Field

The present disclosure relates to temperature sensing circuits. In particular, to temperature sensing circuits for measuring a temperature at a satellite location.

### Summary

According to a first aspect of the present disclosure there is provided a temperature sensing circuit comprising: an ADC having a first terminal, a second terminal and an output terminal; a reference circuit comprising: a first current source configured to provide a first current; a second current source configured to provide a second current; a first active device having a first active area and configured to receive the first current, such that the first active device defines a first current density when it is in use and receiving the first current; a second active device having a second active area and configured to receive the second current, such that the second active device defines a second current density when it is in use and receiving the second current, wherein the first current density is different to the second current density; a comparison block configured to provide a difference signal to the first terminal of the ADC, wherein the difference signal is representative of the difference between a voltage drop across the first active device and a voltage drop across the second active device; satellite circuitry comprising: a satellite current source configured to provide a satellite current; a satellite active device having a satellite active area and configured to receive the satellite current, such that the satellite active device defines a satellite current density when it is in use and receiving the satellite current; a multiplexer comprising: a first input terminal connected to the first active device in order to receive a signal representative of the voltage drop across the first active device; a satellite input terminal connected to the satellite active device in order to receive a signal representative of a voltage drop across the satellite active device; and an output terminal configured to selectively provide one of the signals received at the first input terminal and the satellite input terminal as a reference voltage based on a signal at a select input terminal of the multiplexer, wherein the output terminal of the multiplexer is connected to the second terminal of the ADC; and a controller configured to: provide a first select signal to the select input terminal of the multiplexer in order to cause the multiplexer to provide the signal representative of the voltage drop across the first active device at its output terminal such that the ADC is configured to provide a reference ratio signal, wherein the reference ratio signal is a ratio between the difference signal and the signal representative of the voltage drop across the first active device; provide a second select signal to the select input terminal of the multiplexer in order to cause the multiplexer to provide the signal representative of the voltage drop across the satellite active device at its output terminal, such that the ADC is configured to provide a satellite ratio signal, wherein the satellite ratio signal is a ratio between the difference signal and the signal representative of the voltage drop across the satellite active device; determine a temperature difference between the reference circuit and the satellite active device based on a comparison between the reference ratio signal and the satellite ratio signal.

In one or more embodiments, the temperature sensing circuit further comprises a memory device.

In one or more embodiments, the temperature sensing circuit is configured to retrieve one or more calibration factors from the memory device.

In one or more embodiments, the controller is configured to determine the temperature of the reference circuit based on the reference ratio signal and the one or more calibration factors.

In one or more embodiments, the controller is configured to determine the difference between the temperatures of the reference circuit and the temperature of the satellite active device; and determine the temperature of the satellite circuitry based on the determined temperature of the reference circuit and the difference between the temperatures of the reference circuit and the temperature of the satellite active device.

In one or more embodiments, the size of the first active area is different to the size of the second active area, and the magnitude of the first current is the same as the magnitude of the second current, such that the first current density is different to the second current density.

In one or more embodiments, the size of the first active area is the same as the size of the second active area, and the magnitude of the first current is different to the magnitude of the second current, such that the first current density is different to the second current density.

In one or more embodiments, the size of the first active area is different to the size of the second active area, and the magnitude of the first current is different to the magnitude of the second current, such that the first current density is different to the second current density.

In one or more embodiments, the size of the first active area is the same as the size of the satellite active area, and the magnitude of the first current is the same as the magnitude of the satellite current, such that the first current density is the same as the satellite current density.

In one or more embodiments: the size of the first active area is different to the size of the satellite active area; the magnitude of the first current is the same as the magnitude of the satellite current; and the controller is configured to apply one or more calibration factors to the signal representative of the voltage drop across the satellite active device, such that the signal representative of the voltage drop across the satellite active device is as it would have been if the satellite current density was the same as the first current density.

In one or more embodiments: the size of the first active area is the same as the size of the satellite active area; the magnitude of the first current is different to the magnitude of the satellite current; and the controller is configured to apply one or more calibration factors to the signal representative of the voltage drop across the satellite active device, such that the signal representative of the voltage drop across the satellite active device is as it would have been if the satellite current density was the same as the first current density.

In one or more embodiments, one or more of the active devices are BJTs.

In one or more embodiments: the temperature detection circuit comprises a plurality of satellite circuits, such that each of the plurality of satellite active devices are connected to a respective plurality of satellite input terminals of the multiplexer, such that each of the plurality of satellite multiplexer input terminals is configured to receive a signal representative of a voltage drop across the respective satellite active device; and the output terminal of the multiplexer is configured to selectively provide one of the signals received at the first input terminal and the plurality of satellite input terminals as a reference voltage based on a signal at the select input terminal of the multiplexer.

In one or more embodiments, the controller is configured to: provide a signal to the select input terminal of the multiplexer in order to cause the multiplexer to provide the signal representative of the voltage drop across one of the plurality of satellite active devices at its output terminal, such that the ADC is configured to provide a satellite ratio signal which corresponds to the respective one of the plurality of satellite circuits, wherein the satellite ratio signal is a ratio between the difference signal and the signal representative of the voltage drop across the respective satellite active device; and determine a temperature difference between the reference circuit and the one of the plurality of satellite active devices based on a comparison between the reference ratio signal and the satellite ratio signal.

In one or more embodiments, the controller is configured to provide a signal to the select input terminal of the multiplexer in order to cause the multiplexer to sequentially provide each of the signals representative of the voltage drop across each of the plurality of satellite active devices at its output terminal.

In one or more embodiments, the voltage drop across each individual active device is complementary to absolute temperature, CTAT, and the difference signal is proportional to absolute temperature, PTAT.

In one or more embodiments, the controller applies a scaling factor to the difference signal, such that the sum of the voltage drop across each individual active device and the difference signal is substantially independent of temperature within a temperature range of interest.

In one or more embodiments, the satellite current source is configured to provide a bias current which is proportional to absolute temperature to the satellite active device.

In one or more embodiments, the first terminal of the ADC is an input terminal, and the second terminal of the ADC is a reference terminal. In one or more embodiments, the first terminal of the ADC is a reference terminal, and the second terminal of the ADC is an input terminal. That is: the first terminal of the ADC can be either an input terminal or a reference terminal; and the second terminal of the ADC can be the other one of the input terminal and the reference terminal.

In some embodiments, the reference ratio is directly derivable from the reference ratio signal and the satellite ratio is directly derivable from the satellite ratio signal. In other embodiments, one or more additional processing steps can be applied to determine the reference ratio from the reference ratio signal, and one or more additional processing steps can be applied to determine the satellite ratio from the satellite ratio signal. In some embodiments, the one or more additional processing steps may include accounting for the applied gain.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

## Brief Description of the Drawings

One or more embodiments will now be described by way of example only with reference to the accompanying drawings in which:

Figure 1 shows an example temperature sensing circuit, according to an embodiment of the present disclosure;
Figure 2 shows an example plot of the relationships between voltage and temperature associated with some of the components of Figure 1;

Figure 3 shows an example temperature sensing circuit, according to an embodiment of the present disclosure;

Figure 4 shows an example temperature sensing circuit which includes a plurality of satellite active devices, according to an embodiment of the present disclosure; and

Figure 5 shows another example temperature sensing circuit which includes a plurality of satellite active devices, according to an embodiment of the present disclosure.

**Detailed Description**

For a large system-on-chip (SoC) it is often desirable to measure the die temperature at many different locations on the chip. For SoCs, there is typically a trade-off between chip area and temperature measurement accuracy. This disclosure describes a satellite temperature sensing circuit which, using a ratiometric reference temperature sensor, can achieve high temperature measurement accuracy.

Advantageously, a single reference temperature sensor can be used to read out many satellite temperature sensors. There is no requirement for each satellite temperature sensor to be connected to a supply voltage, since they can all be biased from the reference temperature sensor. Therefore, beneficially, the satellite temperature sensors may be placed in low voltage power domains.

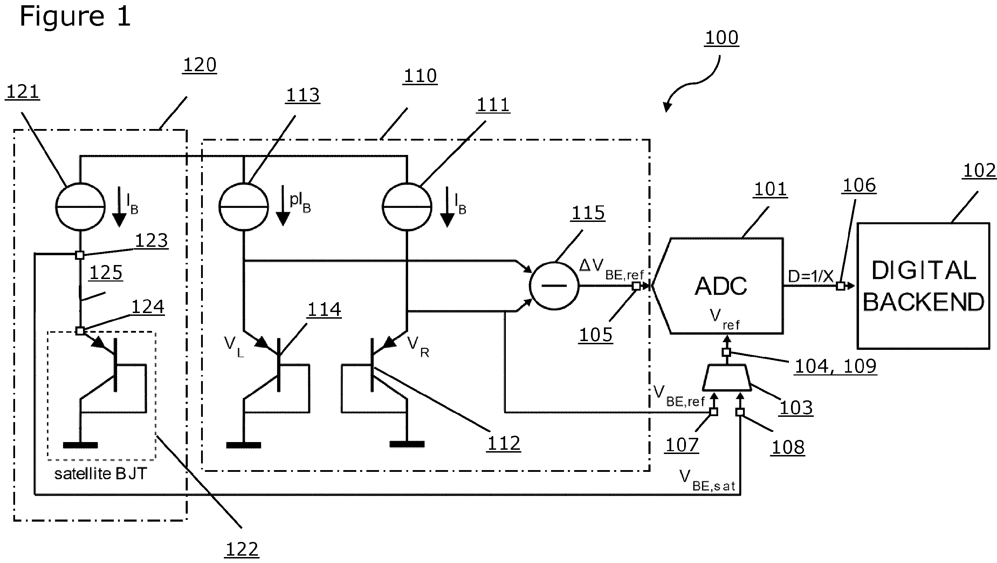

Figure 1 shows an example temperature sensing circuit 100, according to an embodiment of the present disclosure. The temperature sensing circuit 100 includes an ADC 101, a controller 102, a multiplexer 103, a reference circuit 110 and satellite circuitry 120. The controller 102 that is shown in Figure 1 is illustrated as a digital backend that processes an output signal from the ADC 101 and controls the multiplexer 103. It will be appreciated from the description that follows that the functionality of the controller 102 can be implemented by one or more processors, and that the functionality of the controller 102 that is described below is not necessarily performed by the digital backend that is illustrated in Figure 1.

The ADC 101 has a reference terminal 104, an input terminal 105 and an output terminal 106. As is known in the art, the ADC 101 will provide a digital output signal which represents the ratio of the input signal received at the input terminal 105 relative to a reference voltage received at the reference terminal 104.

The reference circuit 110 includes: a first current source 111 configured to provide a first current $I_B$ and a first active device 112. The first active device 112 has a first active area and is configured to receive the first current $I_B$, such that a first current density is defined for the first active device 112 when it is in use and receiving the first current $I_B$. The reference circuit 110 also includes a second current source 113 configured to provide a second current $pI_B$ and a second active device 114. The second active device 114 has a second active area and is configured to receive the second current $pI_B$, such that a second current density is defined for the second active device 114 when it is in use and receiving the second current $pI_B$. In this embodiment the first active device 112 and the second active device 114 are bipolar junction transistors (BJTs), although any suitable component wherein the current through the component exhibits a temperature dependent exponential dependency relative to the voltage across it may be used (that is, $I \sim exp(qv/kT)$, wherein I is current, q is the electron charge, V is voltage across the active area, k is the Boltzmann constant and T is the absolute temperature). Examples of alternative active devices include a dynamic threshold metal-oxide-semiconductor field-effect-transistor (dtMOS) biased in the sub-threshold region and a diode. The active devices may be considered to be temperature sensors for the purposes of this disclosure.

The first current density is different to the second current density. In this example embodiment, the size of the first active area is the same as the size of the second active area, and the magnitude of the first current $I_B$ is different to the magnitude of the second current $pI_B$, such that the first current density is different to the second current density. In particular, in this embodiment the second current $pI_B$ is equal to the first current density $I_B$ multiplied by a scaling factor p, wherein $p \neq 1$. However, the first current density being different to the second density may be achieved in any suitable manner. For example, in some embodiments, the size of the first active area is different to the size of the second active area, and the magnitude of the first current $I_B$ is the same as the magnitude of the second current $pI_B$ (i.e. p = 1), such that the first current density is different to the second current density. In other embodiments, the size of the first active area is different to the size of the second active area, and the magnitude of the first current $I_B$ is different to the magnitude of the second current $pI_B$ (wherein $p \neq 1$), such that the first current density is different to the second current density. In some embodiments, the scaling factor p may be applied to the first current, instead of the second current. In these embodiments, no other adjustments need to be made to the following apparatus and techniques in order to provide the same technical result.

Because the first current density is different to the second current density, the relationship between the voltage drop across each respective active device is different to the voltage drop across the other active device at any particular temperature above absolute zero. Accordingly, a ratio between the difference in voltage drop between the first active device and the second active device and the voltage drop across the first or second active device is representative of the temperature of the reference circuit. Because the first active device 112 and the second active device 114 are functionally defined relative to each other, the numerology 'first' and 'second' may be arbitrarily defined. Throughout this disclosure, the first and second active devices are defined such that it is the voltage drop across the first active device which is used for determining the ratio as mentioned above, not the second active device. In some examples, the active device with the smaller bias current is used as the first active device 112, which results in a lower overall current consumption of the temperature sensing circuit 100.

The reference circuit 110 also includes a summation block 115 (which is an example of a comparison block) which is configured to provide a difference signal $\Delta V_{BE,ref}$ to the input terminal 105 of the ADC 101, wherein the difference signal $\Delta V_{BE,ref}$ is representative of the difference between the voltage drop $V_{BE,ref}$ across the first active device 112 and the voltage drop across the second active device 114. A voltage dropped across an active device in this example is referred to as $V_{BE}$ because the active devices are BJTs, and therefore the voltage dropped across it corresponds to the voltage dropped across the base-emitter junction of the BJT. For ease of understanding, we will refer to the voltage drop across the first active device 112 as $V_{BE,ref}$.

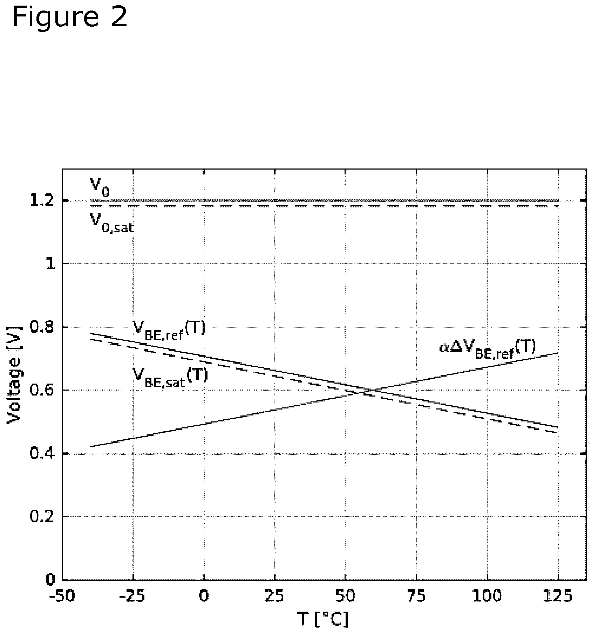

Figure 2 shows an example plot of the relationships between voltage and temperature associated with some of the components of Figure 1.

In this embodiment, $V_{BE,ref}$ is complementary to absolute temperature (CTAT) and the difference signal $\Delta V_{BE,ref}$ is proportional to absolute temperature (PTAT).

In this embodiment, the controller applies a scaling factor $\alpha$ to the difference signal $\Delta V_{BE,ref}$, such that the sum of the signal representative of $V_{BE,ref}$ and the scaled difference signal $\alpha\Delta V_{BE,ref}$ is substantially independent of temperature T, at least within a temperature range of interest. The sum of these signals is represented in the figure by $V_0$.

Using this information, it is possible to calculate the absolute temperature (for example, the temperature in degrees Celsius or Kelvin) of the reference circuit. First, a reference intermediary-temperature signal $\mu_{ref}$ for the reference circuit is generated using equation (1) -

$$\mu_{\mathrm{ref}} = \frac{\alpha}{\alpha + X_{\mathrm{ref}}} = \frac{\alpha\Delta V_{\mathrm{BE,ref}}}{\alpha\Delta V_{\mathrm{BE,ref}} + V_{\mathrm{BE,ref}}} = \frac{\alpha\Delta V_{\mathrm{BE,ref}}}{V_0} \tag{1}$$

- where $X_{ref} = \dfrac{V_{BE,ref}}{\Delta V_{BE,ref}}$. $X_{ref}$ is a non-linear but monotonic changing function of temperature. As is apparent, the reference intermediary-temperature signal $\mu_{ref}$ is comprised of a signal which is dependent on temperature (the scaled difference signal $\alpha\Delta V_{BE,ref}$) and divided by a signal which is constant and independent of temperature $V_0$ (like a bandgap reference voltage). Therefore, the reference intermediary-temperature signal $\mu_{ref}$ is also dependent on temperature in the same way that $\Delta V_{BE,ref}$ is dependent on temperature. The temperature sensing circuit may therefore be calibrated by placing the reference circuit in a known-temperature environment and calculating the reference intermediary-temperature signal $\mu_{ref}$ to determine one or more appropriate calibration factors, allowing the absolute temperature of the reference circuit to be calculated. This calculation is demonstrated in equation (2) -

$$T_{\mathrm{ref}} = A\,\mu_{\mathrm{ref}} + B = A\frac{\alpha\Delta V_{\mathrm{BE,ref}}}{\alpha\Delta V_{\mathrm{BE,ref}} + V_{\mathrm{BE,ref}}} + B = A\frac{\alpha\Delta V_{BE,ref}}{V_0} + B \tag{2}$$

- where $T_{ref}$ is the absolute temperature of the reference circuit, A is a gain factor and B is an offset. In this way, A and B are calibration factors. In some embodiments, the temperature sensing circuit further comprises a memory device, and the temperature sensing circuit is configured to retrieve one or more calibration factors A, B from the memory device, but any other suitable calibration method may be used.

Returning to Figure 1, the temperature sensing circuit 100 includes satellite circuitry 120, which includes a satellite current source 121 configured to provide a satellite current $I_B$. The temperature sensing circuit 100 also includes a satellite active device 122. The satellite active device 122 has a satellite active area and is configured to receive the satellite current $I_B$, such that the satellite active device 122 has a satellite current density when it is in use and receiving the satellite current $I_B$. The satellite circuitry 120 may be located entirely at a satellite location on the chip, i.e. a location that is remote from the reference circuit 110. In some embodiments, the satellite active device 122 is located at the satellite location, and the satellite current source 121 is located with the reference circuit 110. In these embodiments, there is no need for a supply voltage at the satellite location. In this way, the satellite current source 121 may, in some examples, be considered part of the reference circuit 110, as well as or instead of part of the satellite circuitry 120. The satellite location may be near or far away from the reference circuit 110.

In this example, the size of the first active area is the same as the size of the satellite active area, and the magnitude of the first current $I_B$ is the same as the magnitude of the satellite current $I_B$, such that the first current density is the same as the satellite current density. However, in other examples, this may not be the case, as will be discussed below.

We return now to Figure 2. Because the satellite current density is the same as the first current density (or the resulting signal is compensated as such), the relationship between the voltage drop over the satellite active device $V_{BE,sat}$ and temperature is the same as the relationship between $V_{BE,ref}$ and temperature. For ease of understanding, we will refer to the voltage drop across the satellite active device as $V_{BE,sat}$.

This means that the sum of the signal representative of $V_{BE,sat}$ and the scaled difference signal $\alpha\Delta V_{BE,ref}(T)$ is substantially independent of temperature T within at least the temperature range of interest. The difference in level of the sum of these signals relative to $V_0$ represents the difference between the reference circuit and the satellite active device temperature. The sum of these signals is represented in the figure by $V_{0,sat}$, in an example where the satellite active device is at a lower temperature than the reference circuit. In situations where the satellite active device is at a higher temperature than the reference circuit, $V_{0,sat}$ would be greater than $V_0$.

Therefore, a linear transfer of temperature may be obtained at the satellite location by calculating a satellite intermediary-temperature signal $\mu_{sat}$ for the satellite active device which is dependent on temperature in the same way that the reference intermediary-temperature signal $\mu_{ref}$ is dependent on temperature, as a result of the equivalent current densities of the two active devices. This is shown in equation (3) -

$$\mu_{\text{sat}} = \frac{\alpha}{\alpha + X_{sat}} = \frac{\alpha\Delta V_{\text{BE,ref}}}{\alpha\Delta V_{\text{BE,ref}} + V_{\text{BE},sat}} = \frac{\alpha\Delta V_{\text{BE,sat}}}{V_{0,sat}} \qquad (3)$$

- where $X_{sat} = \dfrac{V_{BE,\text{sat}}}{\Delta V_{BE,ref}}$. In this way, the denominator of the satellite intermediary-temperature signal $\mu_{sat}$ is substantially constant with respect to temperature but it will vary depending on the temperature difference between the reference circuit and the satellite active device. Contrary to the reference intermediary-temperature signal $\mu_{ref}$, the satellite intermediary-temperature signal $\mu_{sat}$ is not a direct measurement of the temperature of the satellite active device because it also depends on the unknown temperature difference between the satellite active device and the reference circuit.

A ratio $r$ of the intermediary-temperature signals $\mu_{ref}$, $\mu_{sat}$ may then be calculated, wherein the ratio $r$ is also the ratio between the temperature independent signals $V_{0,sat}$, $V_0$ of the satellite active device and the reference circuit, as shown in equation (4) -

$$r = \frac{\mu_{ref}}{\mu_{sat}} = \frac{\alpha\Delta V_{BE,ref} + V_{BE,sat}}{\alpha\Delta V_{BE,ref} + V_{BE,ref}} = \frac{V_{0,sat}}{V_0} \qquad (4)$$

It follows therefore, that the difference $\Delta V_0$ between the temperature independent signals $V_{0,sat}$, $V_0$ is calculable using this ratio $r$, as shown in equation (5) -

$$\Delta V_0 = V_0 - V_{0,sat} = (1 - r)V_0 \qquad (5)$$

The difference $\Delta V_0$ between the temperature independent signals $V_{0,sat}$, $V_0$ is the same as the difference between $V_{BE,ref}$ and $V_{BE,sat}$. An inversion of the function $V_{BE,ref}(T)$ for the voltage drop dependence of the first active device against temperature may then be used to determine the absolute temperature of the satellite active device -

$$T_{sat} = T(V_{BE,ref} + \Delta V_0) = T(V_{BE,ref}) + \frac{\Delta V_0}{s} \qquad (6)$$

- where the gradient $s = \dfrac{\delta V_{BE,ref}}{\delta T}$. Furthermore, since the calibration factor A (as used above in equation (2)) is determined by the ratio $\dfrac{V_0}{s}$, the temperature $T_{sat}$ of the satellite active circuit as a function of the reference temperature can be calculated as shown in equation (7) -

$$T_{sat} = T_{ref} + (1 - r)A \tag{7}$$

- where $T(V_{BE,ref}) = T_{ref}$. Alternatively, the temperature of the satellite active device may be calculated directly from the satellite intermediary-temperature signal $\mu_{sat}$ if a correction for the gradient and offset is taken into account, as shown below in equation (8) -

$$T_{sat} = \mu_{sat}\, rA + B + (1 - r)A \tag{8}$$

- where A and B are the same calibration factors as used for the reference circuit 110.

Returning to Figure 1, the temperature sensing circuit also includes a multiplexer 103 comprising: a first input terminal 107 connected to the first active device 112 in order to receive a signal representative of $V_{BE,ref}$, a satellite input terminal 108 connected to the satellite active device 122 in order to receive a signal representative of $V_{BE,sat}$, and an output terminal 109 configured to selectively provide one of the signals received at the first input terminal 107 and the satellite input terminal 108 as a reference voltage based on a signal at a select input terminal (not shown) of the multiplexer 103. The output terminal 109 of the multiplexer 103 is connected to the reference terminal 104 of the ADC 101.

The controller 102 is configured to provide a signal to the select input terminal (not shown) of the multiplexer 103 in order to control which of the signals received at its input terminals is provided at its output terminal. More specifically, in order to generate a reference ratio signal, $D_{ref}$, as will be discussed below, the controller 102 provides a first select signal to the select input terminal (not shown) of the multiplexer 103 to cause the multiplexer 103 to connect its first input terminal 107 to its output terminal 109. In this way, the signal representative of $V_{BE,ref}$ is provided at the multiplexer's output terminal 109. As a result, the ADC 101 provides an output signal, which we will refer to as a reference ratio signal $D_{ref}$, that represents the ratio between the difference signal $\Delta V_{BE,ref}$ and the signal representative of $V_{BE,ref}$. Therefore, in this embodiment, the reference ratio signal $D_{ref} = 1/X_{ref} = \dfrac{\Delta V_{BE,ref}}{V_{BE,ref}}$. In embodiments wherein the first active device 112 is the active device with the smaller bias current, the dynamic range of the ADC is better utilised.

Also, in order to generate a satellite ratio signal, $D_{sat}$, the controller 102 provides a second select signal to the select input terminal (not shown) of the multiplexer 103 in order to cause the multiplexer 103 to connect its satellite input terminal 108 to its output terminal 109. In this way, the signal representative of $V_{BE,sat}$ is provided at the multiplexer's output terminal 109. As a result, the ADC 101 provides an output signal, which we will refer to as a satellite ratio signal $D_{sat}$ that represents the ratio between the difference signal $\Delta V_{BE.ref}$ and the signal representative of $V_{BE,sat}$. Therefore, in this embodiment, the satellite ratio signal $D_{sat} = 1/X_{sat} = \dfrac{\Delta V_{BE,ref}}{V_{BE,sat}}$.

For an improved signal-to-noise ratio in the ADC 101, a gain may be applied to the difference signal $\Delta V_{BE,ref}$ such that the maximum input signal is of similar magnitude to the reference voltage (for example it may be marginally smaller than the reference voltage), because the difference signal $\Delta V_{BE,ref}$ is typically much smaller than $V_{BE,ref}$ or $V_{BE,sat}$. In these examples, the applied gain is accounted for by the controller in order to determine the ratios $X_{ref}$ and $X_{sat}$.

In some other embodiments, the input signals to the ADC 101 may be swapped, such that the summation block 115 is configured to provide the difference signal $\Delta V_{BE,ref}$ (with gain applied) to the reference terminal 104 of the ADC 101, and the output terminal 109 of the multiplexer 103 is connected to the input terminal 105 of the ADC. That is, the ADC 101 can be considered as having a first terminal and a second terminal such that: i) the first terminal is either the input terminal 105 or the reference terminal 104; and ii) the second terminal of the ADC is the other one of the input terminal 105 and the reference terminal 104.

The applied gain is useful in the embodiment where the difference signal $\Delta V_{BE,ref}$ is provided to the reference terminal 104 because it can ensure that the ADC 101 reference voltage is larger than the input signal. In these embodiments, the applied gain is accounted for by the controller in order to determine the ratios $X_{ref}$ and $X_{sat}$.

In these embodiments, the reference ratio signal $D_{ref} = X_{ref} = \dfrac{V_{BE,ref}}{\Delta V_{BE,ref}}$ and the satellite ratio signal

$$D_{sat} = X_{sat} = \dfrac{V_{BE,sat}}{\Delta V_{BE,ref}}$$ . In any case, the ratios $X_{ref}$ and $X_{sat}$ are determinable from the output signals of the ADC 101.

In some embodiments, the reference ratio is directly derivable from the reference ratio signal and the satellite ratio is directly derivable from the satellite ratio signal. In other embodiments, one or more additional processing steps are applied to determine the reference ratio from the reference ratio signal, and one or more additional processing steps are applied to determine the satellite ratio from the satellite ratio signal. For example, the one or more additional processing steps may include accounting for the applied gain.

Lastly, the controller 102 can determine a temperature difference between the reference circuit 110 and the satellite active device 122 based on a calculation using the reference ratio signal $D_{ref}$ and the satellite ratio signal $D_{sat}$. For example, the calculation which is made when following the steps of equations (1) to (7) or (8) above.

In other embodiments, the size of the first active area is different to the size of the satellite active area and the magnitude of the first current $I_B$ is the same as the magnitude of the satellite current $I_B$. In these examples, the controller 102 is configured to apply one or more predetermined calibration factors to the signal representative of $V_{BE,sat}$, such that the signal representative of $V_{BE,sat}$ is as it would have been if the satellite current density was the same as the first current density. Such predetermined calibration factors can be determined based on a known relationship between the first current density and the satellite current density or determined during calibration by placing the reference circuit and satellite active device in a known-temperature environment at a known temperature. In other embodiments, the size of the first active area is the same as the size of the satellite active area and the magnitude of the first current $I_B$ is different to the magnitude of the satellite current $I_B$. In these embodiments, the controller 102 is configured to apply one or more predetermined calibration factors to the signal representative of $V_{BE,sat}$, such that the signal representative of $V_{BE,sat}$ is as it would have been if the satellite current density was the same as the first current density. In either case, when calculating the temperature of the satellite active device directly from the satellite intermediary-temperature signal $\mu_{sat}$ (as discussed above in relation to equation (8)), different calibration factors C and D (instead of calibration factors A and B used for the determination of the temperature of the reference circuit), specific to the satellite active device, may be used according to equation (9) -

$$T_{sat} = \mu_{sat}\, rC + D + (1 - r)A \qquad\qquad (9)$$

The wire 125 connecting the satellite current source 121 to the satellite active device 122 after it branches off the multiplexer 103 (that is, the wire 125 between terminals 123 and 124 in the figure) will result in an error of $V_{BE,sat}$ as seen at terminal 124, due to an additional voltage drop across the series resistance of the wire 125. Assuming the input impedance of the reference terminal 104 of the ADC is large, the current flowing through the wire between terminals 123 and 108 will be negligible and does not result in a significant voltage drop across it. When the satellite location is far away from the reference circuit 110, the length of the wire 125 will be large, resulting in a significant series resistance and voltage drop caused by the satellite current travelling through the wire 125. In addition, $V_{BE,sat}$ of the satellite active device 122 will have process spread. Therefore, in some embodiments, the satellite current source 121 is configured to provide a bias current $I_B$, which is PTAT, to the satellite active device 122. In this way, the error voltage from the voltage drop across the wire 125 will also be PTAT, and can therefore be corrected using a single trim parameter $X_{offset,sat}$, using equation (10) below -

$$\mu_{sat} = \frac{\alpha}{\alpha + X_{sat} - X_{offset,sat}} = \frac{\alpha \Delta V_{BE,ref}}{\alpha \Delta V_{BE,ref} + V_{BE,sat} - \Delta V_{BE,ref}\, X_{offset,sat}} \qquad (10)$$

Advantageously, with this trim parameter, any PTAT errors (e.g. the spread in a saturation current $I_s$ of BJT and diode active devices, or the spread of a resistor to generate PTAT bias current, or any other errors which are proportional to kT/q or errors with a varying slope which start at zero with zero error at absolute zero) can be compensated entirely in the digital domain, thereby saving chip space and reducing component cost. In some embodiments, a similar trim parameter is used to compensate any PTAT errors in the reference intermediary-temperature signal $\mu_{ref}$.

In other embodiments, the multiplexer 103 is connected to terminal 124 instead of terminal 123. That is, the multiplexer is connected more closely to the satellite active device 122 than the satellite current source 121 (after the majority of wire 125). In these embodiments, the voltage drop across the wire 125 would not significantly affect $V_{BE,sat}$ at the multiplexer.

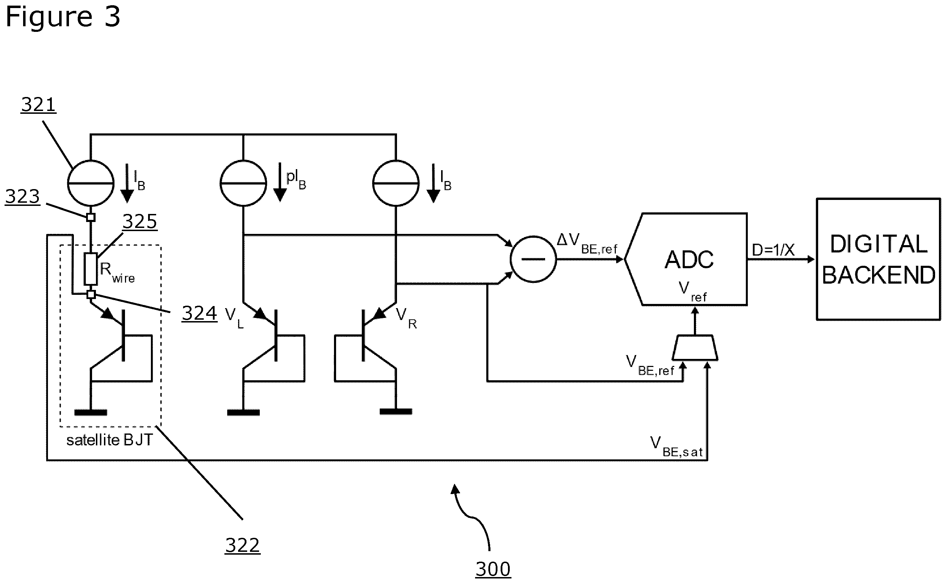

Figure 3 shows an example temperature sensing circuit 300, according to an embodiment of the present disclosure. The example temperature sensing circuit 300 includes a representation of the series resistance of the wire 325 between terminals 323 and 324 to further illustrate the above discussion. In this example, the multiplexer is connected to terminal 324 instead of terminal 323 (that is, the multiplexer is connected more closely to the satellite active device 322 than the satellite current source 321, after the majority of wire 325).

Some further advantages of the temperature sensing circuit as disclosed herein, are that the satellite temperature circuit requires only a satellite active device, a current source and two wires for connection to the remainder of the temperature sensing circuit. This means that the satellite circuitry is easy to implement virtually anywhere it is required on an SoC. Furthermore, because only $V_{BE,sat}$ is measured/sensed remotely and its temperature sensitivity is relatively large compared to that of $\Delta V_{BE}$, the necessary signal from the satellite temperature sensing circuit may be relatively insensitive to disturbances, thereby improving the reliability of the resulting temperature measurements.

In some embodiments, the temperature sensing circuit includes a plurality of satellite active devices (i.e., the temperature sensing circuit includes x satellite circuits).

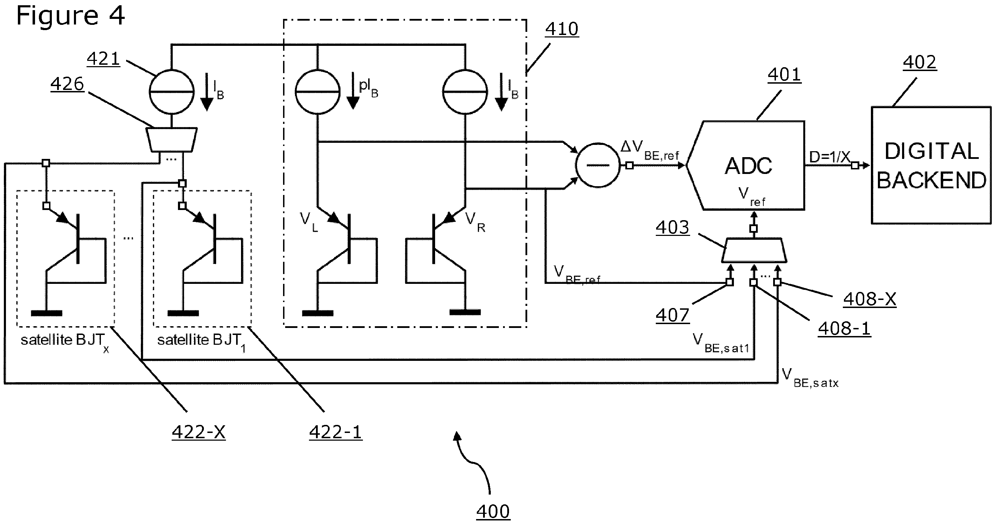

Figure 4 shows an example temperature sensing circuit 400 which includes a plurality of satellite active devices 422-1 to 422-X, according to an embodiment of the present disclosure. In this embodiment, each of the plurality of satellite active devices 422-1 to 422-X are connected to a respective plurality of satellite input terminals 408-1 to 408-X of the multiplexer 403. In this way, each of the plurality of satellite multiplexer input terminals 408-1 to 408-X is configured to receive a signal representative of a voltage drop across the respective satellite active device 422-1 to 422-X. We will refer to the voltage drop across each one of the plurality of satellite active devices 422-1 to 422-X as $V_{BE,sat,n}$, wherein n = 1 to x. In these embodiments, the output terminal of the multiplexer 403 is configured to selectively provide either the signal received at the first input terminal 407 or the signal received at one of the plurality of satellite input terminals 408-1 to 408-X (i.e., the signal representative of any $V_{BE,sat,n}$) as a reference voltage for the ADC 401 based on an appropriate select signal received at the select input terminal of the multiplexer 403.

In these embodiments, for any particular satellite active device n, the controller 402 is configured to provide a select signal to the select input terminal of the multiplexer 403 in order to cause the multiplexer 403 to provide the signal representative of $V_{BE,sat,n}$ at its output terminal, such that the ADC 401 is configured to provide a satellite ratio signal $D_{sat,n}$ which corresponds to satellite active device n. The satellite ratio signal $D_{sat,n}$ is therefore a ratio between the difference signal $\Delta V_{BE,ref}$ and the signal representative of $V_{BE,sat,n}$. Secondly, the controller 402 is configured to determine a temperature difference between the reference circuit 410 and one of the plurality of satellite active devices 422-1 to 422-X (satellite active device n) based on a comparison between the reference ratio signal $D_{ref}$ and the satellite ratio signal $D_{sat,n}$. Advantageously, the temperature sensing circuit 400 can therefore be used to measure the temperature at a plurality of different locations on the SoC, as required.

In this embodiment, the temperature sensing circuit 400 also comprises a demultiplexer 426, which includes an input terminal connected to the satellite current source 421 and an input terminal connected to each of the plurality of satellite active devices 422-1 to 422-X. In this embodiment, for any particular satellite active device n, the controller 402 is configured to provide the select signal (or a corresponding select signal) to a select input terminal (not shown) of the demultiplexer 426 in order to cause the demultiplexer 426 to provide the satellite current to the satellite active device n. The controller 402 is also configured to provide the select signal to the multiplexer 403 in order to cause the multiplexer 403 to provide the signal representative of $V_{BE,sat,n}$ at its output terminal, such that the ADC 401 is configured to provide a satellite ratio signal $D_{sat,n}$ which corresponds to satellite active device n. In this way, only a single satellite current source 421 is required to allow the temperature sensing circuit 400 to measure the temperature at a plurality of different locations on the SoC, as required.

In embodiments wherein the temperature sensing circuit 400 includes a plurality of satellite circuits 422-1 to 422-X, the controller 402 may be configured to selectively provide signals to the select input terminal of the multiplexer 403 in order to cause the multiplexer 403 to sequentially provide each of the signals representative of $V_{BE,sat,1}$ to $V_{BE,sat,x}$ at its output terminal. In this way, the temperature sensing circuit 400 can measure the temperature at a plurality of different locations on the SoC, using only a single measurement of the reference circuit 410. This has the effect of improving the efficiency of the temperature sensing circuit 400.

In other embodiments, the controller may be configured to selectively provide a signal to the select input terminal of the multiplexer 403 in order to cause the multiplexer 403 to provide the signal representative of the voltage drop across only a satellite active device of interest ($V_{BE,sat,n}$). In this way, the temperature sensing circuit 400 can reduce the number of unnecessary measurements taken. In either case, it is beneficial to ensure that the period of time between the ADC 401 providing the reference ratio signal $D_{ref}$ and the ADC 401 providing each satellite ratio signal $D_{sat,n}$ is short (for example, below a predetermined threshold). In this way, the temperature sensing circuit 400 can provide a more accurate temperature comparison between the reference circuit 410 and the satellite active device under consideration (satellite active device n) because the likelihood and therefore impact of any potential temperature fluctuations is reduced.

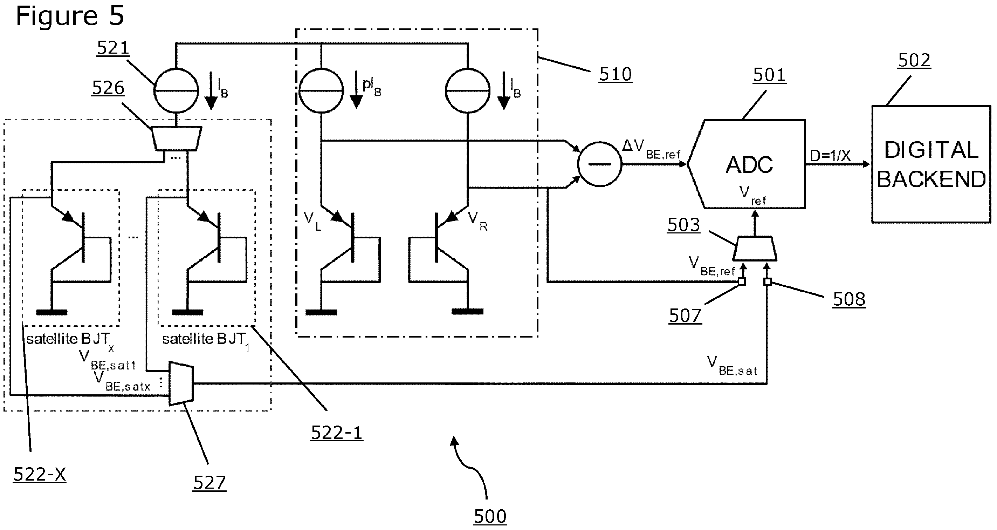

Figure 5 shows another example temperature sensing circuit 500 which includes a plurality of satellite active devices 522-1 to 522-X, according to an embodiment of the present disclosure. In this embodiment, the multiplexer 503 includes a first input terminal 507 connected to the first active device and a satellite input terminal 508. The temperature sensing circuit 500 also includes a satellite multiplexer 527, which includes an input terminal connected to each of the satellite active devices 522-1 to 522-X and an output terminal connected to the satellite input terminal 508. In this embodiment, the controller is configured to the control signal (or a plurality of corresponding control signals) to the multiplexer 503, the demultiplexer 526 and the satellite multiplexer 527, such that the satellite current is provided to the satellite active device of interest and such that the signal representative of the voltage drop across the satellite active device of interest is provided to the satellite input terminal 508 of the multiplexer 503, and subsequently to the reference terminal of the ADC 501.

The wire connection from each of the satellite active devices 522-1 to 522-X to the reference circuit 510 and the multiplexer 503 can be long. Therefore, in some embodiments, shielding wires (not shown) are used to suppress disturbances, which increases required area within the SoC which is needed for the wiring. It can therefore be advantageous to place both the satellite current source 521 and the satellite multiplexer 527 close to a group of satellite active devices. In these embodiments, the satellite active devices 522-1 to 522-x may be grouped into a plurality of groups, wherein each group of satellite active devices corresponds to a respective region of the SoC. In these embodiments, the $V_{BE}$ sense wires (that is, the wires connected between the satellite active devices 522-1 to 522-X and the satellite multiplexer 527) need to be tapped after the demultiplexer 526. In these embodiments, the multiplexer switches may be implemented with transistors which each have a resistance that varies with temperature and therefore the voltage across them. The voltage drop across these switches will not be PTAT and so cannot be compensated by the trim parameter $X_{offset,sat}$.

In addition to the advantages discussed above, one or more examples disclosed within this document can provide the following advantages:

i) only a single bias current can be used for a temperature measurement at a satellite location;
ii) because only a single voltage drop is measured at the satellite location, the circuit is less sensitive to disturbances; and
iii) the present disclosure allows compensation for PTAT errors including static series resistance when biased by a PTAT bias current in the digital domain by using only a single trim parameter $X_{offset,sat}$, as discussed above in equation (10).

The present disclosure is applicable in any large SoC which requires a plurality of temperature monitors across a die. The present disclosure also allows for the implementation of many temperature monitors at various satellite locations across the die or even external to the SoC.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

**Claims**

1. A temperature sensing circuit comprising:

an ADC having a first terminal, a second terminal and an output terminal;

a reference circuit comprising:

a first current source configured to provide a first current;
a second current source configured to provide a second current;
a first active device having a first active area and configured to receive the first current, such that the first active device defines a first current density when it is in use and receiving the first current;
a second active device having a second active area and configured to receive the second current, such that the second active device defines a second current density when it is in use and receiving the second current, wherein the first current density is different to the second current density;
a comparison block configured to provide a difference signal to the first terminal of the ADC, wherein the difference signal is representative of the difference between a voltage drop across the first active device and a voltage drop across the second active device;

satellite circuitry comprising:

a satellite current source configured to provide a satellite current;
a satellite active device having a satellite active area and configured to receive the satellite current, such that the satellite active device defines a satellite current density when it is in use and receiving the satellite current;

a multiplexer comprising:

a first input terminal connected to the first active device in order to receive a signal representative of the voltage drop across the first active device;
a satellite input terminal connected to the satellite active device in order to receive a signal representative of a voltage drop across the satellite active device; and
an output terminal configured to selectively provide one of the signals received at the first input terminal and the satellite input terminal as a reference voltage based on a signal at a select input terminal of the multiplexer, wherein the output terminal of the multiplexer is connected to the second terminal of the ADC; and

a controller configured to:

provide a first select signal to the select input terminal of the multiplexer in order to cause the multiplexer to provide the signal representative of the voltage drop across the first active device at its output terminal such that the ADC is configured to provide a reference ratio signal, wherein the reference ratio signal is indicative of a reference ratio, wherein the reference ratio is a ratio between the difference signal and the signal representative of the voltage drop across the first active device;
provide a second select signal to the select input terminal of the multiplexer in order to cause the multiplexer to provide the signal representative of the voltage drop across the satellite active device at its output terminal, such that the ADC is configured to provide a satellite ratio signal, wherein the satellite ratio signal is indicative of a satellite ratio, wherein the satellite ratio is a ratio between the difference signal and the signal representative of the voltage drop across the satellite active device; and
determine a temperature difference between the reference circuit and the satellite active device based on a comparison between the reference ratio and the satellite ratio.

2. The temperature sensing circuit of claim 1, wherein:

the temperature sensing circuit further comprises a memory device,
the temperature sensing circuit is configured to retrieve one or more calibration factors from the memory device, and

the controller is configured to:

determine the temperature of the reference circuit based on the reference ratio signal and the one or more calibration factors,
determine the difference between the temperatures of the reference circuit and the temperature of the satellite active device; and
determine the temperature of the satellite circuitry based on the determined temperature of the reference circuit and the difference between the temperatures of the reference circuit and the temperature of the satellite active device.

3.  The temperature sensing circuit of claim 1 or claim 2, wherein the size of the first active area is different to the size of the second active area, and the magnitude of the first current is the same as the magnitude of the second current, such that the first current density is different to the second current density.

4.  The temperature sensing circuit of claim 1 or claim 2, wherein the size of the first active area is the same as the size of the second active area, and the magnitude of the first current is different to the magnitude of the second current, such that the first current density is different to the second current density.

5.  The temperature sensing circuit of claim 1 or claim 2, wherein the size of the first active area is different to the size of the second active area, and the magnitude of the first current is different to the magnitude of the second current, such that the first current density is different to the second current density.

6.  The temperature sensing circuit of any preceding claim, wherein the size of the first active area is the same as the size of the satellite active area, and the magnitude of the first current is the same as the magnitude of the satellite current, such that the first current density is the same as the satellite current density.

7.  The temperature sensing circuit of any of claims 1 to claim 5, wherein:

    the size of the first active area is different to the size of the satellite active area;
    the magnitude of the first current is the same as the magnitude of the satellite current; and
    the controller is configured to apply one or more calibration factors to the signal representative of the voltage drop across the satellite active device, such that the signal representative of the voltage drop across the satellite active device is as it would have been if the satellite current density was the same as the first current density.

8.  The temperature sensing circuit of any of claims 1 to claim 5, wherein:

    the size of the first active area is the same as the size of the satellite active area;
    the magnitude of the first current is different to the magnitude of the satellite current; and
    the controller is configured to apply one or more calibration factors to the signal representative of the voltage drop across the satellite active device, such that the signal representative of the voltage drop across the satellite active device is as it would have been if the satellite current density was the same as the first current density.

9.  The temperature sensing circuit of any preceding claim, wherein one or more of the active devices are BJTs.

10. The temperature sensing circuit of any preceding claim, wherein:

    the temperature detection circuit comprises a plurality of satellite circuits, such that each of the plurality of satellite active devices are connected to a respective plurality of satellite input terminals of the multiplexer, such that each of the plurality of satellite multiplexer input terminals is configured to receive a signal representative of a voltage drop across the respective satellite active device;
    the output terminal of the multiplexer is configured to selectively provide one of the signals received at the first input terminal and the plurality of satellite input terminals as a reference voltage based on a signal at the select input terminal of the multiplexer;
    the controller is configured to:

        provide a signal to the select input terminal of the multiplexer in order to cause the multiplexer to provide the signal representative of the voltage drop across one of the plurality of satellite active devices at its output terminal, such that the ADC is configured to provide a satellite ratio signal which corresponds to the respective one of the plurality of satellite circuits, wherein the satellite ratio signal is a ratio between the difference signal and the signal representative of the voltage drop across the respective satellite active device;
        determine a temperature difference between the reference circuit and the one of the plurality of satellite active devices based on a comparison between the reference ratio signal and the satellite ratio signal.

11. The temperature sensing circuit of claim 10, wherein:
    the controller is configured to provide a signal to the select input terminal of the multiplexer in order to cause the multiplexer to sequentially provide each of the signals representative of the voltage drop across each of the plurality of satellite active devices at its output terminal.

12. The temperature sensing circuit of any preceding claim, wherein:

the voltage drop across each individual active device is complementary to absolute temperature, CTAT, and the difference signal is proportional to absolute temperature, PTAT; and
the controller applies a scaling factor to the difference signal, such that the sum of the voltage drop across each individual active device and the difference signal is substantially independent of temperature within a temperature range of interest.

13. The temperature sensing circuit of any preceding claim, wherein the satellite current source is configured to provide a bias current which is proportional to absolute temperature to the satellite active device.

14. The temperature sensing circuit of any preceding claim, wherein the first terminal of the ADC is an input terminal, and the second terminal of the ADC is a reference terminal.

15. The temperature sensing circuit of any one of claims 1 to 13, wherein the first terminal of the ADC is a reference terminal, and the second terminal of the ADC is an input terminal.

# Figure 1

Figure 2

Figure 3

## Figure 4

EP 4 779 277 A1

Figure 5

EP 4 779 277 A1

Europäisches
Patentamt

European
Patent Office

Office européen
des brevets

# EUROPEAN SEARCH REPORT

**Application Number**

**EP 25 15 2753**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JIN JING ET AL: "A CMOS Temperature Sensor for MEMS-based Frequency Source", 2021 PHOTONICS & ELECTROMAGNETICS RESEARCH SYMPOSIUM (PIERS), IEEE, 21 November 2021 (2021-11-21), pages 1279-1284, XP034078500, DOI: 10.1109/PIERS53385.2021.9694790 [retrieved on 2022-01-26] * the whole document * | 1-15 | INV. G01K7/01 G01K3/14 G01K1/02 G06K19/07 H03M1/12 |
| A | US 2011/200070 A1 (MAKINWA KOFI AFOLABI ANTHONY [NL] ET AL) 18 August 2011 (2011-08-18) * paragraph [0036] - paragraph [0041]; figure 3 * | 1-15 | |
| A | US 2018/217009 A1 (YOUSEFZADEH BAHMAN [NL] ET AL) 2 August 2018 (2018-08-02) * paragraph [0015] - paragraph [0028]; figure 1 * | 1-15 | |

**TECHNICAL FIELDS SEARCHED (IPC)**

G01K

The present search report has been drawn up for all claims

| Place of search | Date of completion of the search | Examiner |
|---|---|---|
| The Hague | 10 July 2025 | Rosello Garcia, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 2753

This annex lists the patent family members relating to the patent documents cited in the above-mentioned European search report.
The members are as contained in the European Patent Office EDP file on
The European Patent Office is in no way liable for these particulars which are merely given for the purpose of information.

10-07-2025

| Patent document cited in search report | Publication date | Patent family member(s) | Publication date |
|---|---|---|---|
| US 2011200070 A1 | 18-08-2011 | EP 2355358 A1 <br> US 2011200070 A1 | 10-08-2011 <br> 18-08-2011 |
| US 2018217009 A1 | 02-08-2018 | NONE | |

EPO FORM P0459

For more details about this annex : see Official Journal of the European Patent Office, No. 12/82